# EUROPEAN PATENT SPECIFICATION

(11) **EP 0 398 365 B1**
(45) Date of publication and mention of the grant of the patent: **11.09.1996**
(21) Application number: 90109477.1
(22) Date of filing: 18.05.1990
(51) Int. Cl.: H01L 21/00

(54) **Multiple chamber staged-vacuum semiconductor wafer processing system**
Mehrkammer-Vakuumvorrichtung mit abgestuften Vakuumniveaus zur Behandlung von Halbleiterwafern
Système à plusieurs chambres à vide étagé de manipulation de plaquettes semi-conductrices

(30) Priority: 19.05.1989 US 355008
(43) Date of publication of application: 22.11.1990
(60) Divisional application: 95112690.3
(73) Proprietor: APPLIED MATERIALS, INC., Santa Clara California 95054-3299 (US)
(72) Inventor: Tepman, Avi, Cupertino, California 95014 (US); Grunes, Howard, Santa Cruz, California 95062 (US); Somekh, Sasson, Los Altos Hills, California 94022 (US); Maydan, Dan, Los Altos Hills, California 94022 (US)
(74) Representative: Diehl, Hermann O. Th., Dr.

(56) References cited:
- EP-A- 0 244 951
- EP-A- 0 272 141
- WO-A-87/07309
- US-A- 4 825 808

## Description

### Background of the Invention

The present invention relates generally to semiconductor wafer vacuum processing systems and to single wafer, cassette-to-cassette, robot vacuum processing systems.

In order to decrease contamination and to enhance through-put, a number of recently introduced single-wafer processing chambers use a system configuration comprising a wafer transfer robot which transports wafers between a cassette load lock and plural/multiple vacuum processing chambers. Access (1) between the individual process chambers and (2) between the robot chamber and the load lock chamber is via slit valves which selectively isolate the process chambers from the robot and the robot from the load lock chamber. This configuration permits processing in one or more chambers while wafers are being loaded or unloaded at other process chambers or at the load lock chamber and permits random access, in vacuo wafer transfer from one processing chamber to another via the robot chamber.

An article entitled "Dry Etching Systems: Gearing Up for Larger Wafers", in the October, 1985 issue of Semiconductor International magazine, pages 48-60, discloses such a system and specifically, a four-chamber dry etching system in which a robot in a pentagonal-shaped housing serves four plasma etching chambers and a cassette load/unload load lock chamber mounted on the robot housing.

European patent application EP-A-0 272 141 discloses a multiple chamber processing system that includes a plurality of separate, isolatable chambers. The system allows the simultaneous performance of different processing steps, such as etching and CVD without breaking system vacuum. Thus, the system locally isolates the various process chambers such that wafers may be transferred within the system without exposing the system to the ambient, i.e. without breaking vacuum.

U.S. Patent No. 4 825 808 discloses a multiple chamber processing system that includes gate valves which are independently operable to seal various chambers within the system and thus allow the simultaneous performance of different processing steps within the system at different processing pressures, if desired. Independent ventilating systems are provided to the respective chambers to improve isolation between the chambers and thereby allow possibly interfering processing steps to proceed at the same time.

Despite the increased vacuum isolation provided by such state-of-the-art systems, to our knowledge typically such systems have difficulty providing commercially acceptable throughput for high vacuum processes, for example, physical vapor processes such as sputtering. specifically, the time required to pump down processing chambers or their load lock chambers to their base level, following loading of wafers into the chambers, is excessive.

The present invention therefore provides an improved multiple chamber staged vacuum semiconductor wafer processing system according to independent claims 1 and an operation method according to independent claims 13 . Further advantageous features are evident from the dependent claims.

The present invention provides a processing system for workpieces such as semiconductor wafers which is configured to minimize the time required to pump down the systems chambers to their base vacuum level after loading of wafers therein.

The invention helps to decreased contamination and increase throughput by pre-cleaning and otherwise pre-treating wafers within the system prior to their entering high vacuum regions.

The invention provides a system as described above which is adapted for minimizing the pump down time and, thus, increasing throughput for very high vacuum chambers, for example, for physical vapor processing chambers such as those used for sputtering.

Besides this, the invention also provides a vacuum processing system which enhances processing capability and throughput by providing separate isolatable, wafer transport paths.

The multiple chamber staged vacuum semiconductor wafer processing system, achieves various of the above objectives and comprises: a multiplicity of isolatable communicating regions including at least a vacuum load lock chamber; a vacuum workpiece-processing chamber and an intermediate workpiece transport region; and vacuum means communicating with the isolatable regions for establishing a base vacuum level in the regions and a vacuum gradient across the system from region-to-region. Preferably, the workpiece transport region comprises first and second vacuum chambers, including respective first and second robot means therein for loading and unloading workpieces; and a pair of passages interconnecting the first and second robot-containing chambers for providing separate transport paths therebetween. First and second workpiece processing chambers or groups of such chambers can be provided in communication with the first and the second robot-containing chamber, respectively. These first and second processing chambers are isolated one from the other by the robot-containing chambers and passages and, consequently, can be used for processing at different vacuum levels and/or using incompatible gas chemistry, and without cross-contamination.

Preferably, our system includes first and second vacuum load lock chambers in communication with a first one of the robot-containing chambers for supplying and receiving workpieces. The dual load locks enhance throughput in that one can be open (to the atmosphere) for loading and unloading of workpieces, while the rest of the system is at vacuum and transporting workpiece internally and/or processing workpieces.

The passages include a chamber therein for treating workpieces prior to transfer from one robot-containing chamber or transfer station to the other. For example, such chambers may be used for pre-cleaning semiconductor wafers before they enter a high vacuum transfer station. This pre-treatment isolation decreases contamination of the transfer station and processing chambers, decreases vacuum pump down time, and, thus, increases throughput.

The staged-vacuum system may comprise a plurality of semiconductor wafer processing chambers; a wafer loading unloading station preferably comprising two load lock chambers for supplying and receiving wafers; a plurality of chambers interposed between and providing a serial transfer path between the load/unload station and the processing chambers; and slit valves which are situated along the transfer paths and interposed between adjacent chambers for selectively sealing the chambers to isolate adjacent chambers one from the other. Also, a vacuum system communicates with the vacuum chambers for establishing a selected base vacuum level in each isolated chamber and a vacuum gradient across the system from chamber-to-chamber, thereby minimizing the time required to pump down the chambers to their selected base vacuum level.

The staged-vacuum system may comprise a plurality of semiconductor wafer processing chambers; a wafer loading unloading station preferably comprising two load lock chambers for supplying and receiving wafers; and a chamber housing including first and second wafer transfer chambers communicating with one another along a first path from the first wafer transfer chamber via a first intermediate processing chamber to the second wafer transfer chamber and along a second path from the second wafer transfer chamber via a second intermediate processing chamber to the first wafer transfer chamber. The loading unloading station communicates with the first wafer transfer chamber and the semiconductor wafer processing chambers communicate with the second wafer transfer chamber to complete the system path from load/unload station to processing chambers.

In method aspect, the present invention is embodied in a method of transporting workpieces in vacuo, comprising transferring selected workpieces from said first vacuum chamber to said second vacuum chamber along a first passageway interconnecting the chambers and returning selected wafers from the second to the first chamber via the second passageway interconnecting the chambers.

The method of transporting workpieces through a vacuum system may comprise loading the workpieces at a vacuum load lock station; sequentially transferring the workpieces within the system through isolated regions of increasing vacuum levels to a vacuum processing chamber for selected processing of the workpiece; and upon completion of the selected processing, returning the wafer to the load lock station.

### Brief Description of the Drawings

The above and other aspects of our invention are described in the enclosed drawings in which:
FIG. 1 is a schematized top plan view of a presently preferred embodiment of our staged-vacuum, multiple chamber semiconductor wafer processing system;
FIG. 2 is a perspective view of a presently preferred embodiment of a magnetically coupled co-axial drive robot used in the system of FIG. 1; and
FIGS. 3 and 4 are plan views of the robot and associated linkage showing the robot arm in the retracted position (FIG. 3) and in the extended position (FIG. 4).

### Detailed Description of the Invention

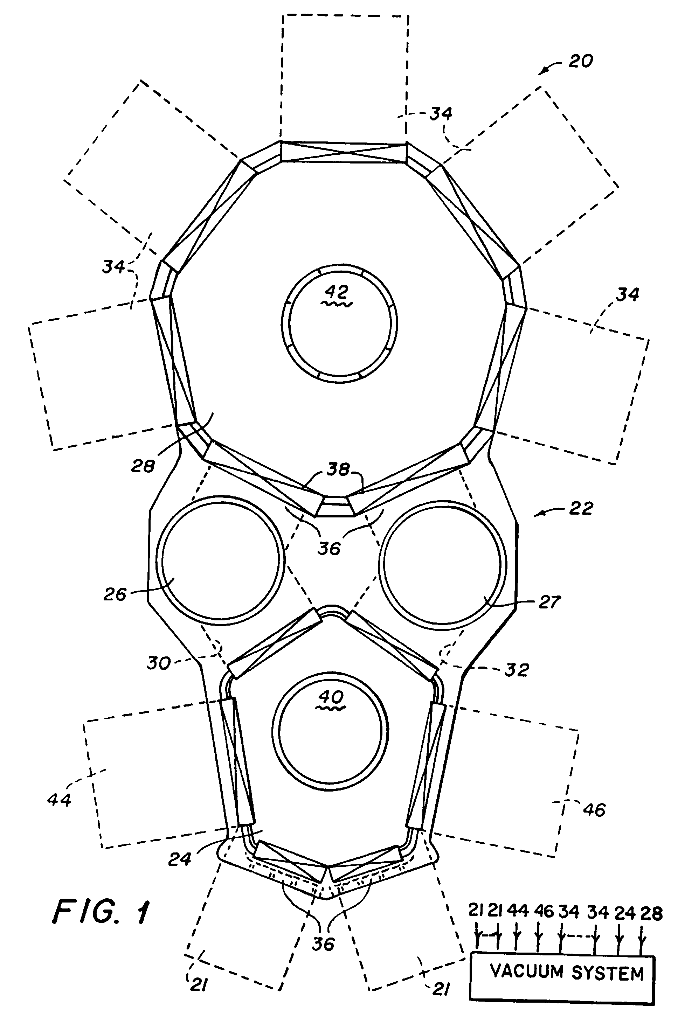

FIG. 1 is a schematic plan view of the configuration of a presently preferred embodiment 20 of our staged-vacuum semiconductor wafer processing system. The system includes a housing 22 which defines four chambers: a robot buffer chamber 24 at one end, a transfer robot chamber 28 at the opposite end, and a pair of intermediate processing or treatment chambers 26 and 27. Although one or more load lock chambers 21 may be used, preferably two such chambers are mounted to the buffer chamber and in communication with the interior of the buffer robot chamber via access ports 36 and associated slit valves 38. A plurality of vacuum processing chambers 34 (illustratively five) are mounted about the periphery of the transfer robot station. (As used here, "plurality" means two or more.) The chambers 34 may be adapted for various types of processing including etching and/or deposition. Access is provided to and between each of the chambers by an associated port 36 and gate valve 38.

The robot chambers 24 and 28 communicate with one another via the intermediate processing or treatment chambers 26 and 27 (also called "treatment" chambers). Specifically, intermediate treatment chamber 26 is located along a corridor or pathway 30 which connects the transfer robot chamber 28 to the buffer robot chamber 24. Similarly, the second intermediate treatment chamber 27 is located along a separate corridor or pathway 32 which connects the robots 28 and 24. These separate paths between the two robot or transfer chambers permit one path to be used for loading or unloading while the system is being used for wafer processing treatment and, thus, provide increased throughput. Please note, the chambers 26 and 27 can be dedicated to pre-treating (e.g., plasma etch cleaning and/or heating) of the wafers before processing in chambers 34 or post-treating (e.g., cool-down) of the wafers following treatment in chambers 34; alternatively, one or both of the chambers 26 and 27 can be adapted for both pre-treatment and post-treatment.

Preferably, the housing 22 is a monolith, i.e., it is machined or otherwise fabricated of one piece of material such as aluminum to form the four chamber cavities 24, 26, 27 and 28 and the interconnecting corridors or pathways 30 and 32. The use of the monolith construction facilitates alignment of the individual chambers for wafer transport and also eliminates difficulties in sealing the individual chambers.

One typical operational cycle of wafer transport through the system 20 is as follows. Initially, RΘ buffer robot 40 in chamber 24 picks up a wafer from a cassette load lock 21 and transports the wafer to chamber 26 which illustratively etch cleans the surface of the wafer. RΘ transfer robot 42 in chamber 28 picks up the wafer from the pre-cleaning chamber 26 and transfers the wafer to a selected one of the preferably high vacuum processing chambers 34. Following processing, transfer robot 42 can transfer the wafer selectively to one or more of the other chambers 34 for processing. Then, following use of this random access-type transfer capability, the transfer robot 42 transfers the wafer to intermediate processing chamber 27 which illustratively is a cool-down chamber. After the cool-down cycle, buffer robot 40 retrieves the wafer from the chamber 27 and returns it to the appropriate cassette load lock chamber 21.

As alluded to above, the system 20 is uniquely designed so that each chamber stage (main processing chambers 34/transfer robot chamber 42/intermediate processing chambers 26, 27/buffer robot chamber 24/load lock chambers 21) can be isolated from all the other chambers. None of the chambers or stages, with the exception of the cassette load lock(s) 21, is vented to atmosphere during processing. In addition, during wafer transfer, only two adjacent chambers need be in communication at any time. As a result, variations in vacuum level and, specifically, reductions in the vacuum level during wafer transfer can be minimized by using a vacuum pumping system 50, FIG. 1, to provide a vacuum gradient across the system from the cassette load lock 21 to the vacuum processing chambers 34. The staged vacuum is applied across the system with the degree of vacuum increasing in order from the cassette load locks 21 to the processing chambers 34. Consequently, the time required to pump down chamber 34 to its base vacuum level subsequent to the loading of a wafer therein is minimized and very high degrees of vacuum can be used in the processing chambers 34 without lengthy pump down times and, thus, without adversely affecting system throughput. Also, since the wafers can be pre-cleaned and/or pre-heated before entering high vacuum, there is less system contamination and throughput is increased.

In addition to the enhanced vacuum isolation, throughput and processing versatility provided by the intermediate stage chambers 26 and 27, the above-mentioned stations or chambers 44 and 46 can be mounted on the buffer robot chamber 24 to provide still additional processing isolation, flexibility and throughput enhancement. For example, chamber 44 may be an orienter which is used to orient the wafer flats prior to processing. Alternatively, an entire cassette of wafers in load lock chamber 21 may be oriented one at a time preparatory to transfer to the processing chambers. Chamber 46 may also be dedicated to pre-processing treatment. Alternatively, one or both of the chambers 44 and 46 may be used for post-processing treatment, for both pre-processing and post-processing treatment, or for processing itself. These chambers 44 and 46 are very effectively isolated from the processing chambers 34 by the intervening individually isolated buffer chamber 24, transport paths 26 and 27 (and associated chambers) and transfer chamber 28. Thus, chambers 44 and 46 can be conveniently used for processes which require a different (and/or incompatible) chemistry and/or different (typically lower) pressure relative to the group of processing chambers 34. For example, the high degree of isolation facilitates the use of corrosive gas chemistry in the chambers 34 without affecting the atmosphere and processing/treatment in the chambers 44, 46, and vice versa.

In a presently preferred embodiment, buffer robot 40 is the dual four-bar link robot disclosed in allowed Maydan et al patent application, entitled "Multi-Chamber Integrated Process System", U.S. Serial No. 283,015, which application is incorporated by reference. This robot is preferred for the use in the buffer chamber 24 in part because it combines a folded, very compact configuration and footprint with a relatively long reach and, thus, the capability to service the cassette load lock(s) 21, the buffer stage treatment/processing chambers 44, 46 and the intermediate stage processing treatment chambers 26, 27.

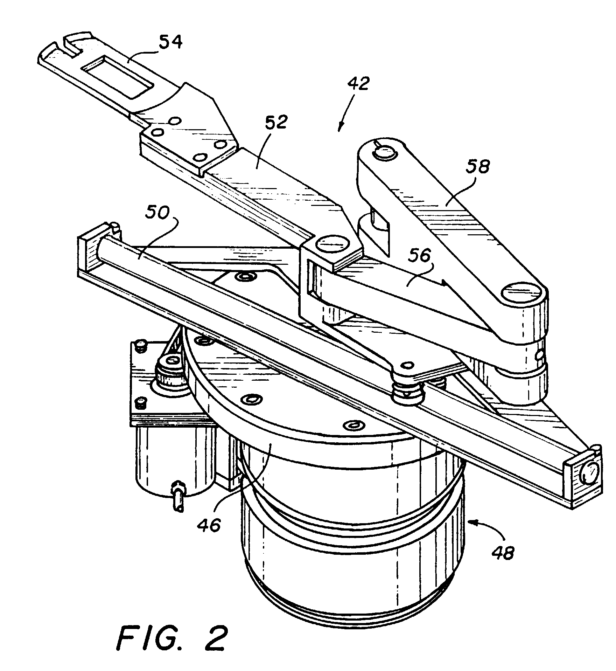

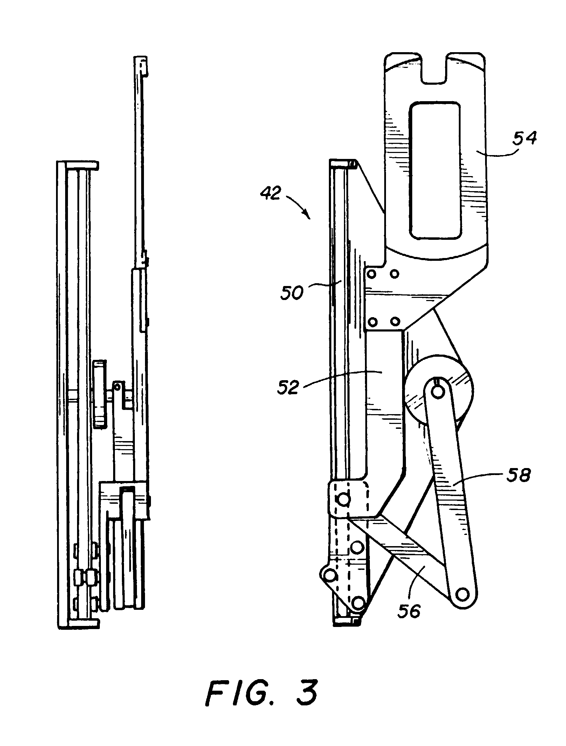

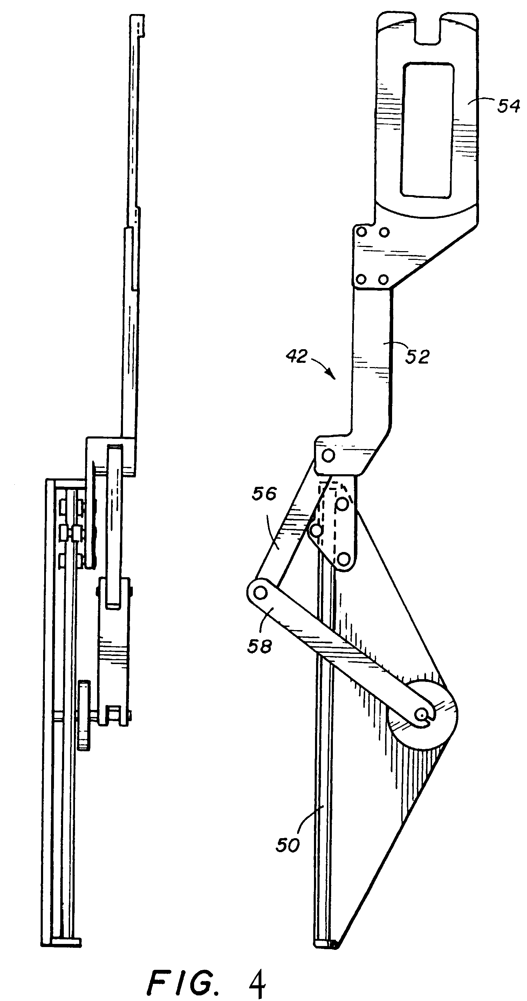

The presently preferred transfer robot 42 is depicted in FIGS. 2, 3 and 4. The prime criteria satisfied by this robot include, first, a long reach; secondly, minimization of the number of gears and other moving parts within the very high vacuum which is used in processes such as physical vapor deposition and; thirdly, effective sealing for such high vacuum environments. Robot 42 comprises a support plate 46 which is sealingly mounted to the base plate of the robot cavity. A magnetic-coupling, concentric-shaft drive system 48 is mounted to the base plate external to the vacuum chamber 28 and incorporates rotational drive means which are magnetically coupled to concentric shafts (not shown) to effect the RΘ movement of the robot. A slide 50 is mounted on one of the concentric shafts and is reversibly rotated with that shaft to impart e movement to the robot. A water arm 52 having a wafer-holding pocket 54 at one end is mounted at the other end via a linkage system comprising pivot arms 56 and 58 to the second concentric shaft (not shown) of the magnetic-coupled drive system. Rotation of the second shaft in opposite directions pivots the links 56 and 58, thereby effecting R translational movement of the arm 54 between the retracted position shown in FIG. 3 and the extended position shown in FIG. 4.

## Claims

1. A multiple chamber staged-vacuum semiconductor wafer processing system, comprising:
a plurality of semiconductor wafer processing chambers (34),
at least one wafer loading/unloading station (21) for supplying and receiving wafers,
a chamber housing (22) including first (24) and second (28) wafer transfer chambers communicating with one another along a first transfer path (30) from the first wafer transfer chamber to the second wafer transfer chamber via a first intermediate processing chamber (26) and along a second transfer path (32) from the second wafer transfer chamber via a second intermediate processing chamber (27) to the first wafer transfer chamber, the at least one loading/unloading station (21) being mounted to and communicating with the first wafer transfer chamber (24) and the semiconductor wafer processing chambers (34) being mounted to and communicating with the second wafer transfer chamber (28);
valve means (38) situated along said transfer paths and interposed between adjacent chambers and intermediate processing chambers selectively sealing said adjacent chambers to selectively isolate said adjacent chambers and intermediate processing chambers one from the other, and
vacuum means (50) communicating with said chambers for establishing a vacuum gradient across the system.

2. The system of claim 1 wherein the semiconductor wafer processing chambers are selected from deposition chambers and etching chambers.

3. The system of claim 1 or 2, the semiconductor wafer processing chambers including at least a physical vapor deposition chamber.

4. The systems of claim 3, wherein the first intermediate processing chamber (26) is adapted for semiconductor wafer cleaning.

5. The systems of claim 3 or 4, wherein the second intermediate processing chamber (27) is a wafer cool down chamber.

6. The system of claim 5 wherein the intermediate processing chambers are adapted for treating a wafer prior or subsequent to processing in the semiconductor wafer processing chambers.

7. The system of one of claims 3 to 6, the first and second wafer transfer chambers (24,28) each having a robot (40,42) mounted therein for respectively
(a) reciprocally transferring wafers between the at least one loading/unloading station (21) and the intermediate processing chambers (26,27) and
(b) for reciprocally transferring wafers between individual ones of the semiconductor wafer processing chambers (34) and the intermediate processing chambers (26,27).

8. The system of claim 7, wherein the robot (42) in the wafer transfer chamber (28) comprises a slide (50) mounted within the chamber for horizontal reciprocal rotation, a wafer holding arm (52) mounted on the slide for reciprocal sliding movement, a pair of co-axial shafts, a first one of the shafts connected to the slide for imparting reciprocal horizontal rotation to the slide and the second shaft being connected via link means to the wafer holding arm for translating reciprocal rotational movement of said second shaft into reversible sliding movement of said wafer holding arm.

9. The system of one of the preceding claims in which the at least one loading/unloading station (21) comprises:
a wafer queueing load lock chamber for inputting wafers into and retrieving wafers from the system.

10. The system of one of claims 7 to 9, in which the first wafer transfer chamber (24) is a relatively small chamber and the second wafer transfer chamber (28) is a relatively large chamber.

11. The system of claim 10 wherein said vacuum means (50) selectively provides a staged vacuum in the system with a relatively low degree of vacuum in the load lock chamber and a relatively high degree of vacuum in the processing chambers; and further comprising:
computer means for controlling processing within the semiconductor wafer processing chambers and selectively transferring wafers from said load lock chamber via the first transfer path to selected semiconductor wafer processing chambers and from selected semiconductor wafer processing chambers via the second transfer path to the load lock chamber.

12. The system of claim 11, wherein the vacuum means are provided for establishing a selected base vacuum level in each chamber to produce said vacuum gradient across the system from chamber-to-chamber.

13. A method of transferring semiconductor wafers in vacuo, in the system of one of claims 1 to 12, comprising transferring selected workpieces from said first wafer transfer chamber to said second wafer transfer chamber along the first of two transfer paths (30,32) interconnecting the wafer transfer chambers and returning selected wafers from the second to the first wafer transfer chamber via the second of said two transfer paths (30,32).

## Patentansprüche

1. Mehrkammerstufenvakuumsystem zur Verarbeitung von Halbleiterwafern mit:
einer Mehrzahl von Halbleiterwaferverarbeitungskammern (34),
mindestens einer Waferbeladungs-/-entladungsstation (21) zur Zufuhr und Aufnahme von Wafern,
einem Kammergehäuse (22) mit einer ersten (24) und einer zweiten (28) Waferübertragungskammer, die entlang eines ersten Übertragungspfads (30) von der ersten Waferübertragungskammer zur zweiten Waferübertragungskammer über eine erste Zwischenverarbeitungskammer (26) und entlang eines zweiten Übertragungspfads (32) von der zweiten Waferübertragungskammer über eine zweite Zwischenverarbeitungskammer (27) zur ersten Waferübertragungskammer miteinander in Verbindung stehen, wobei die mindestens eine Beladungs-/Entladungsstation (21) an der ersten Waferübertragungskammer (24) angebracht ist und mit dieser in Verbindung steht, und die Halbleiterwaferverarbeitungskammern (34) an der zweiten Waferübertragungskammer (28) angebracht sind und mit dieser in Verbindung stehen;
Ventilmitteln (38), die entlang der Übertragungspfade angeordnet sind und zwischen benachbarten Kammern und Zwischenverarbeitungskammern liegen, und die wahlweise die benachbarten Kammern abdichten, um wahlweise die benachbarten Kammern und Zwischenverarbeitungskammern eine von der anderen abzutrennen, und
Vakuummitteln (50), die mit den Kammern zur Schaffung eines Vakuumgradienten über das System in Verbindung stehen.

2. System gemäß Anspruch 1, bei dem die Halbleiterwaferverarbeitungskammern aus Auftragungskammern und Ätzkammern ausgewählt sind.

3. System gemäß Anspruch 1 oder 2, wobei die Halbleiterwaferverarbeitungskammern mindestens eine physikalische Aufdampfungskammer umfassen.

4. Systeme gemäß Anspruch 3, bei denen die erste Zwischenverarbeitungskammer (26) auf die Halbleiterwaferreinigung ausgerichtet ist.

5. Systeme gemäß Anspruch 3 oder 4, bei denen die zweite Zwischenverarbeitungskammer (27) eine Waferabkühlkammer ist.

6. System gemäß Anspruch 5, bei dem die Zwischenverarbeitungskammern auf die Behandlung eines Wafers vor einer oder anschließend an eine Verarbeitung in den Halbleiterwaferverarbeitungskammern ausgerichtet sind.

7. System gemäß einem der Ansprüche 3 bis 6, bei dem die erste und die zweite Waferübertragungskammer (24, 28) jeweils einen darin angebrachten Roboter (40, 42) zur
(a) reziproken Übertragung von Wafern zwischen der mindestens einen Beladungs-/Entladungsstation (21) und den Zwischenverarbeitungskammern (26, 27) bzw.
(b) reziproken Übertragung von Wafern zwischen einzelnen Halbleiterwaferverarbeitungskammern (34) und Zwischenverarbeitungskammern (26, 27)
aufweisen.

8. System gemäß Anspruch 7, bei dem der Roboter (42) in der Waferübertragungskammer (28) ein Gleitstück (50), welches innerhalb der Kammer zur horizontalen reziproken Drehung angebracht ist, einen Waferhaltearm (52), welcher auf dem Gleitstück zur reziproken Gleitbewegung angebracht ist, und ein Paar koaxialer Wellen aufweist, wobei eine erste der Wellen mit dem Gleitstück verbunden ist, um dem Gleitstück eine reziproke horizontale Drehung zu verleihen, und die zweite Welle über Verbindungsmittel mit dem Waferhaltearm verbunden ist, um eine reziproke Drehbewegung der zweiten Welle in eine reversible Gleitbewegung des Waferhaltearms zu übertragen.

9. System gemäß einem der vorhergehenden Ansprüche, bei dem die mindestens eine Beladungs-/Entladungsstation (21) folgendes aufweist:
eine Waferladeschleusenkammer zum Einsetzen von Wafern in das und Zurückholen von Wafern aus dem System.

10. System gemäß einem der Ansprüche 7 bis 9, bei dem die erste Waferübertragungskammer (24) eine relativ kleine Kammer und die zweite Waferübertragungskammer (28) eine relativ große Kammer ist.

11. System gemäß Anspruch 10, bei dem das Vakuummittel (50) wahlweise ein Stufenvakuum in dem System mit einem relativ geringen Vakuumgrad in der Ladeschleusenkammer und einem relativ hohen Vakuumgrad in den Verarbeitungskammern zur Verfügung stellt; mit des weiteren:
Computermitteln zur Steuerung der Verarbeitung innerhalb der Halbleiterwaferverarbeitungskammern und wahlweisen Übertragung von Wafern von der Ladeschleusenkammer über den ersten Übertragungsweg zu ausgewählten Halbleiterwaferverarbeitungskammern und von ausgewählten Halbleiterwaferverarbeitungskammern über den zweiten Übertragungsweg zu der Ladeschleusenkammer.

12. System gemäß Anspruch 11, bei dem die Vakuummittel zur Schaffung eines ausgewählten Basisvakuumniveaus in jeder Kammer zur Erzeugung des Vakuumgradienten über das System von Kammer zu Kammer zur Verfügung gestellt sind.

13. Verfahren zur Übertragung von Halbleiterwafern im Vakuum in dem System gemäß einem der Ansprüche 1 bis 12 mit der Übertragung ausgewählter Werkstücke von der ersten Waferübertragungskammer zu der zweiten Waferübertragungskammer entlang dem ersten von zwei Übertragungspfaden (30, 32), welche die Waferübertragungskammern miteinander verbinden, und dem Rücktransport ausgewählter Wafer von der zweiten zu der ersten Waferübertragungskammer über den zweiten der beiden Übertragungspfade (30, 32).

## Revendications

1. Système à plusieurs chambres de traitement de plaquettes semi-conductrices, à vide étagé, comprenant :
une pluralité de chambres de traitement (34) de plaquettes semi-conductrices,
au moins une station de chargement/déchargement (21) de plaquettes pour fournir et recevoir des plaquettes,
une enceinte (22) de chambres comprenant une première (24) et une seconde (28) chambres de transfert de plaquettes communiquant l'une avec l'autre le long d'un premier trajet de transfert (30) depuis la première chambre de transfert de plaquettes vers la seconde chambre de transfert de plaquettes via une première chambre de traitement intermédiaire (26), et le long d'un second trajet de transfert (32) depuis la seconde chambre de transfert de plaquettes, via une seconde chambre de traitement intermédiaire (27), vers ladite première chambre de transfert de plaquettes, ladite au moins une station de chargement/déchargement (21) étant montée sur, et communiquant avec, la première chambre de transfert de plaquettes (24) et lesdites chambres de traitement (34) de plaquettes semi-conductrices étant montées sur, et communiquant avec, la seconde chambre de transfert de plaquettes (28) ;
des vannes (38), situées le long desdits trajets de transfert et interposées entre les chambres adjacentes et les chambres de traitement intermédiaires, fermant sélectivement de manière étanche lesdites chambres adjacentes pour isoler sélectivement lesdites chambres adjacentes et lesdites chambres de traitement intermédiaires l'une de l'autre, et
des moyens à vide (50) communiquant avec lesdites chambres pour établir un gradient de vide d'un côté à l'autre du système.

2. Système selon la revendication 1, dans lequel lesdites chambres de traitement de plaquettes semi-conductrices sont choisies entre les chambres de dépôt et les chambres de gravure.

3. Système selon la revendication 1 ou 2, dans lequel lesdites chambres de traitement de plaquettes semi-conductrices comprennent au moins une chambre de dépôt en phase vapeur.

4. Système selon la revendication 3, dans lequel la première chambre de traitement intermédiaire (26) est adaptée au nettoyage de plaquettes semi-conductrices.

5. Système selon la revendication 3 ou 4, dans lequel la seconde chambre de traitement intermédiaire (27) est une chambre de refroidissement de plaquettes.

6. Système selon la revendication 5, dans lequel les chambres de traitement intermédiaires sont adaptées au traitement d'une plaquette avant ou après le traitement dans les chambres de traitement de plaquettes semi-conductrices.

7. Procédé selon l'une des revendications 3 à 6, dans lequel les première et seconde chambres de transfert de plaquettes (24, 28) comportent chacune un robot (40, 42) monté dans lesdites chambres pour respectivement
(a) transférer selon un mouvement alternatif lesdites plaquettes entre ladite au moins une station de chargement/déchargement (21) et les chambres de traitement intermédiaires (26, 27) et
(b) pour transférer, selon un mouvement alternatif, les plaquettes entre les chambres individuelles de traitement (34) de plaquettes semi-conductrices et les chambres de traitement intermédiaires (26, 27).

8. Système selon la revendication 7, dans lequel le robot (42) prévu dans la chambre de transfert de plaquettes (28) comprend un chariot (50) monté au sein de la chambre pour être animé d'un mouvement de rotation alternatif horizontal, un bras de maintien de plaquette (52) monté sur le chariot en vue d'un mouvement de coulissement alternatif, une paire d'axes coaxiaux, un premier desdits axes étant connecté au chariot pour conférer au chariot une rotation horizontale alternative et le second axe étant connecté, via un moyen à bielles, au bras de maintien de plaquettes pour transformer le mouvement de rotation alternatif dudit second axe en un mouvement de coulissement réversible dudit bras de maintien de plaquette.

9. Système selon l'une des revendications précédentes, dans lequel ladite au moins une station de chargement/déchargement (21) comprend :
un sas de chargement pour les plaquettes en attente en vue de faire pénétrer les plaquettes dans le système et d'enlever les plaquettes dudit système.

10. Système selon l'une des revendications 7 à 9, dans lequel la première chambre de transfert de plaquettes (24) est une chambre relativement petite et la seconde chambre de transfert de plaquettes (28) est une chambre relativement grande.

11. Système selon la revendication 10, dans lequel lesdits moyens à vide (50) fournissent sélectivement un vide étagé au système avec un degré relativement faible de vide dans le sas de chargement et un degré de vide relativement élevé dans les chambres de traitement ; et comprenant en outre :
des moyens informatiques pour commander le traitement au sein des chambres de traitement de plaquettes semi-conductrices et le transfert sélectif des plaquettes depuis ledit sas de chargement, via ledit premier trajet de transfert, vers des chambres de traitement sélectionnées de plaquettes semi-conductrices et depuis des chambres de traitement sélectionnées de plaquettes semi-conductrices, via le second trajet de transfert, vers ledit sas de chargement.

12. Système selon la revendication 11, dans lequel lesdits moyens à vide sont prévus pour établir un niveau de vide de base sélectionné dans chaque chambre pour produire ledit gradient de vide d'un côté à l'autre du système, d'une chambre à une autre.

13. Procédé de transfert de plaquettes semi-conductrices sous vide dans le système selon l'une des revendications 1 à 12, comprenant le transfert de pièces à travailler sélectionnées depuis ladite première chambre de transfert de plaquettes vers ladite seconde chambre de transfert de plaquettes, le long du premier des deux trajets de transfert (30, 32) interconnectant les chambres de transfert de plaquettes, et pour ramener les plaquettes sélectionnées depuis la seconde vers la première chambre de transfert de plaquettes via le second desdits trajets de transfert (30, 32).
